(19) Europäisches Patentamt
European Patent Office
Office européen des brevets

(11) **EP 4 194 861 B1**

(12) **EUROPEAN PATENT SPECIFICATION**

(45) Date of publication and mention
of the grant of the patent:
**10.07.2024 Bulletin 2024/28**

(21) Application number: **21212663.5**

(22) Date of filing: **07.12.2021**

(51) International Patent Classification (IPC):
*G01R 27/16* (2006.01)     *G01R 23/167* (2006.01)
*G01R 19/00* (2006.01)     *G01R 19/25* (2006.01)

(52) Cooperative Patent Classification (CPC):
**G01R 27/16; G01R 19/0007; G01R 19/2513;
G01R 23/167**

(54) **LOW-IMPACT POWER GRID PROBING**

SONDIERUNG EINES STROMNETZES MIT GERINGEN AUSWIRKUNGEN

SONDAGE DE RÉSEAU ÉLECTRIQUE À FAIBLE IMPACT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**14.06.2023 Bulletin 2023/24**

(73) Proprietor: **Hitachi Energy Ltd
8050 Zürich (CH)**

(72) Inventor: **Nilsson, Torsten
722 26 Västerås (SE)**

(74) Representative: **AWA Sweden AB
Box 45086
104 30 Stockholm (SE)**

(56) References cited:
**DE-A1- 102019 214 533     GB-A- 2 567 460
US-B1- 6 208 945**

**Description**

**TECHNICAL FIELD**

The present invention relates to a method for determining characteristics of a power grid, and a data processing device, computer program product and computer-readable medium for carrying out the method. The present invention further relates to a power grid system for determining characteristics of a power grid.

**BACKGROUND**

Grid characteristics data for a power grid can be obtained by probing the power grid. Probing the grid involves generating a probe signal and injecting the probe signal into the grid. The probe signal will induce a response in the grid according to the characteristics thereof. Thus, the response can be measured as a means for determining characteristics of the power grid.

When obtaining characteristics of a power grid, known methods may focus on particular frequencies of interest, such as the fundamental frequency (50 Hz or 60 Hz typically, depending on country), or harmonics thereof (i.e. 100, 150, 200 Hz or 120, 180, 240 Hz etc.). An example of a characteristic is the impedance of a power grid, which may vary with frequency along the power grid signal. For example, the impedance of the power grid in the neighborhood of 50 Hz may be lower or higher than the impedance in the neighborhood of 150 Hz.

Known techniques for obtaining characteristics of a power grid involve injecting a probe signal at a particular frequency of interest. For example, the impedance at 250 Hz may be under investigation. Thus, a probe signal at 250 Hz may be injected. In order to produce an identifiable response in the power grid signal, a relatively high level of injection may be required, such as 0.1 pu ('per unit') or more, where 1 pu is 100% of the amplitude of the native harmonic, and the probe signal may have a broadband coverage. The power grid signal may be obtained before and after injection. Thus, the response signal corresponding to the injection can be inferred from these measurements, and thus characteristics of the grid can be determined therefrom. Signals with a bandwidth of 1 kHz or more can be injected, but such signals require large amplitude to produce an identifiable response.

A disadvantage of using such broadband and/or high-magnitude probe signals is that a lot of disturbance is introduced into the grid, and interference from disturbed components of the power grid signal can make the collection of grid data difficult. A power grid customer may often have certain constraints on the amount of permitted disturbance, for example according to an agreement between the customer and the provider of the power grid. Therefore, in order to minimize disturbances to the power grid, the broadband probe signal may only be injected for a short duration, such as 5 minutes.

Thereafter, the data obtained for the determined grid characteristics may be relied upon for the following hour(s) or day(s) until the next short-term broadband probe signal is injected. Prior art is known from US6208945, GB2567460, and DE102019214533.

**SUMMARY OF INVENTION**

Viewed from one aspect, there is provided, according to claim 1, a computer-implemented method for determining characteristics of a power grid. The method may be carried out by a data processing device such as a stand-alone or integrated computing device, or the method may be stored as instructions in a computer program product, or on a computer-readable medium, such that the method is carried out when said computer program is executed by a computer.

According to this aspect, the method comprises determining a signal filter for extracting a sample signal from a power grid signal, the signal filter being configured to filter frequencies outside of a filter bandwidth from the power grid signal.

The signal filter may be a digital filter, a fast Fourier transform (FFT) and/or any other hardware or software component that is suitable for filtering (i.e., rejecting or attenuating) signals having a frequency outside of a prescribed filter bandwidth. As an example, a digital filter having a bandwidth of 1 Hz may be able to substantially filter out frequencies below 98.5 Hz and above 99.5 Hz (i.e., if centered at 99 Hz). As a further example, a FFT having a sample time of 4 seconds may have a filter bandwidth of 0.25 Hz, being the inverse of 4 seconds, and thus may be able to resolve a power grid signal in frequency space to a resolution of 0.25 Hz.

The signal filter may not have a total attenuation outside of the filter bandwidth. The filter bandwidth may be defined as the bandwidth outside of which signals are attenuated to below an acceptable threshold.

The term 'signal' is used to refer to, for example, a measured voltage or current signal. In an alternating current (AC) power grid, the power grid signal may comprise a sinusoidally oscillating voltage/current having a fundamental component with a frequency of, e.g., 50 Hz or 60 Hz (depending on the country), as well as a plurality of harmonic components that are multiples of the fundamental frequency. For example, in a power grid having a 50 Hz fundamental frequency, the plurality of components may have frequencies of 100 Hz, 150 Hz, 200 Hz, and so on.

The fundamental component of the power grid signal may typically have the greatest amplitude, whilst the harmonic components may have a lesser amplitude. Highly numbered harmonics (i.e. 10th or greater) may have even smaller amplitudes.

The power grid signal may have further components that are not harmonics of the fundamental frequency, which may be referred to as inter-harmonic components. In some examples, a customer of a power grid provider may request that the power grid signal be free from inter-harmonic components and that the fundamental frequency and/or harmonics thereof be largely undisturbed by interference, noise, and/or other disturbances, which may cause problems for loads connected to said power grid.

As part of a customer's requirements, it may be requested that disturbances, such as inter-harmonic disturbances, are kept at a minimum.

The present method further comprises generating a probe signal for injecting into the power grid to investigate a component of the power grid signal at a frequency of interest, the probe signal having an injection frequency different to the frequency of interest. The probe signal is superimposed over a power grid control signal for a grid-connected power converter.

In the interests of determining characteristics of the power grid, the present approach relates to the injection of probe signals which, when received in the power grid, will be detectable in the sample signal. The frequency of interest may be the fundamental frequency, a harmonic thereof, or some other frequency at which a determination of characteristics of the grid is desired. However, as probe signals may disturb the power grid signal, it is an object of the present method to reduce the impact of such probing.

Thus, according to the present method, the injection frequency is spaced from the frequency of interest such that the sample signal is resolvable, using the determined signal filter, from the component of the power grid signal, the sample signal responding to the probe signal according to the one or more characteristics of the power grid at the frequency of interest. Here, 'resolvable' is intended to mean that the component of the power grid signal is substantially rejected/isolated by the signal filter such that the sample signal can be individually isolated without contributions from the component, which may negatively affect the accuracy of characteristics determined based on the sample signal.

By selecting a signal filter having an appropriate filter bandwidth for resolving the injected probe signal from the frequency of interest (e.g. the fundamental frequency), the probe signal can be injected with a relatively low amplitude (for example 0.01 pu or less) whilst still inducing a resolvable sample signal that is useful for the determination of grid characteristics.

In some examples, the method may further comprise obtaining an amplitude threshold corresponding to a maximum tolerance for grid disturbance, and generating the probe signal with an amplitude less than or equal to the amplitude threshold. Thus, by introducing such a constraint, it can be ensured that the injected probe signal does not induce any significant disturbance.

Accordingly, the method then comprises injecting the probe signal into the power grid, extracting the sample signal from the power grid signal using the signal filter, and determining the one or more characteristics of the power grid at the frequency of interest based on the sample signal.

The extracted sample signal may comprise a voltage signal and/or a current signal. Furthermore, for power grids having multiple phases, one probe signal may be injected per phase (having negative and/or positive sequence components), and/or one sample signal per phase may be extracted. Thereafter, the sample signal may be processed by signal processing means in order to determine the one or more characteristics of the grid. For example, a voltage part of the sample signal and a current part of the sample signal may be processed using a level comparator and an impedance calculator in order to determine the impedance of the power grid at the frequency of interest.

As the signal filter and the spacing of the injected probe signal from the frequency of interest are related, the choice of signal filter (and more specifically its filter bandwidth) and/or said spacing can be tuned to optimize the method. In some examples, there may be constraints on the spacing of the injected signal (at the injection frequency) from the frequency of interest, or there may be constraints on the bandwidth of the signal filter due to a relationship between filter bandwidth and filter response time.

In an example, a 4 second FFT could be used, which gives a filter bandwidth for resolving a sample signal of 0.25 Hz (i.e. the inverse of 4 seconds). Consequently, it may be preferable to space the injected probe signal from the component under investigation by a multiple of the filter bandwidth (e.g. 5 times the filter bandwidth). Thus, the probe signal may be injected at least 1.25 Hz from the component in order to be clearly resolvable therefrom. With the present approach, it is possible to inject a probe signal having an amplitude below that which could cause detectable problems from a customer. Thus, constant monitoring of one or more characteristics of the grid can be achieved.

For example, a series of FFTs may be taken, each having the same or different response times/sample times, depending on the implementation. As used herein, using/taking an FFT may mean calling a sub-routine to process a chosen number of stored consecutive samples from a power grid signal (e.g. $2^x$ samples) to generate the FFT output such that the number of samples may correspond to desired filter bandwidth. Such FFT calls can then be repeated according to how often a monitoring update is desired. As FFT is a processing-efficient technique, processing time may be advantageously short. Thus, for example, a FFT for 4 seconds' worth of input samples can be repeated with e.g. 1 second repetition intervals.

If the method is implemented using digital filters (instead of FFT), then the chosen filter bandwidth may result in a certain output settling time, i.e. a delayed output. However, as with FFTs, monitoring updates can be repeated as often or as seldom as desired without being restricted by chosen filter bandwidth.

In practice, the component and/or the generated probe signal may have some bandwidth themselves in the frequency space. This may be caused by frequency drifts in the grid and/or imprecise generation of the prove signal. In this case, it is preferable to inject the probe signal further from the central frequency of the component (e.g. by half of the bandwidth of the component signal) so as to improve the ability of the signal filter to resolve the sample signal from the component in the power grid signal. Taking the previous example, instead of injecting the probe signal at least 1.25 Hz from the component, the probe signal may instead be injected at least 2-3 Hz from the component.

The difference between the injection frequency and the frequency of interest may be referred to as a frequency delta. Characteristics of the power grid, such as impedance, may be slowly evolving with respect to frequency. That is, the impedance of the power grid at 50 Hz may be substantially similar to that at 53 Hz. Thus, the characteristics of the power grid determined from the extraction of the sample signal may viably inform on the characteristics of the power grid at the frequency of interest.

An increased frequency delta allows for a greater ability to resolve the sample signal from the component under investigation. However, a decreased frequency delta allows for greater accuracy in determining characteristics of the grid at the frequency of interest, as said characteristics are less likely to have substantially changed with frequency.

In some examples, determining the one or more characteristics of the power grid at the frequency of interest based on the sample signal may comprise determining the one or more characteristics of the power grid at the injection frequency based on the sample signal, and then extrapolating from the injection frequency to the frequency of interest. The extrapolation may be linear or according to some predefined function, which may change depending on the characteristic of the power grid being determined and its known evolution with frequency.

According to such an approach, an improved accuracy of the determined characteristics may be achieved. Furthermore, if extrapolation is used, the frequency delta may be increased in order to improve its resolvability without necessarily sacrificing accuracy.

In other examples, the probe signal comprises a pair of probe signals, or a plurality of probe signals having at least a first probe signal and a second probe signal. The first probe signal may have a first injection frequency greater than the frequency of interest, whilst the second probe signal may have a second injection frequency less than the frequency of interest.

In such examples, determining the one or more characteristics of the power grid at the frequency of interest based on the sample signal may comprise determining the one or more characteristics of the power grid at the first injection frequency based on a first sample signal responding to the first probe signal, and determining the one or more characteristics of the power grid at the second injection frequency based on a second sample signal responding to the second probe signal. Then, the determination of grid characteristics at the frequency of interest can be made by interpolating between the first injection frequency and the second injection frequency to the frequency of interest.

Interpolation may provide further accuracy improvements than those offered by extrapolation. For example, the evolution of the characteristic with frequency may be mitigated against by injected above and below the frequency of interest. Moreover, by using a plurality of probe signals, the uncertainty in the ultimately determined value for the characteristic can be reduced by combining the measured uncertainty for each extracted sample signal.

According to some examples, it may be desired to investigate a plurality of different components of the power grid signal at a respective plurality of frequencies of interest. For example, it may be desired to determine the impedance of the power grid at the second harmonic and the third harmonic frequencies. In this case, the method may comprise generating a plurality of probe signals for injecting into the power grid to investigate said respective plurality of components, each probe signal having a respective injection frequency.

When injecting a plurality of probe signals, either for investigating a plurality of components or for the purposes of later interpolation, each probe signal may be spaced from its respective component by a same distance (in frequency space) or by a different distance, depending on the particular constraints of the implementation.

As previously mentioned, components of the power grid signal may be subject to frequency drift. That is, a particular component, such as the fundamental (e.g. at 50 Hz) may drift from exactly 50 Hz over time, for example by 1-2 Hz either side. Thus, in some examples, the frequency delta may be maintained such that the injection frequency tracks/follows changes in the frequency of the component from the frequency of interest. To give an example, a frequency delta may be maintained at 5 Hz such that, if it is detected that a component at 50 Hz has drifted to 51 Hz, the injection frequency may be adjusted from 55 Hz to 56 Hz in order to preserve the frequency delta of 5 Hz.

By tracking the changes of the component in this way, it can be ensured that the extracted sample signal remains resolvable from the component signal even if the component under investigation is subject to frequency drift.

Some components of the power grid signal may have greater disturbance than others. For example, some components may experience greater frequency drift (which can manifest as a wide bandwidth in frequency space in an FFT) or may have a large degree of noise, for example from nonlinear electrical loads. The signal quality of different components, e.g. in respect of local noise, frequency drift etc., can be measured and compared.

According to some examples, the method may further comprise identifying a plurality of components of the power grid signal, determining a signal quality of each of the plurality of components, and selecting the component that will be used for investigation from the plurality of components based on the component having the greatest signal quality.

In this way, the extracted sample signal can more accurately represent the characteristics of the power grid, as fewer disturbances are incorporated into the signal. Thus, a more accurate determination of characteristics of the power grid can be achieved.

The method may include scanning frequencies in the vicinity/neighborhood (e.g. +/- 10 Hz) of the frequency of interest to determine one or more frequencies that have a least disturbance, and determining the injection frequency(/ies) for the probe signal(s) accordingly.

In some cases, a power grid signal may be temporarily impacted by a transient signal, also referred to as simply a 'transient'. Transients may be caused by internal events in the power grid or nearby events such as faults. Grid transients have broad spectrum and will to certain extent excite narrow band filters. Thus, the grid data collected during a transient can be unreliable.

In some examples, the present method may further comprise detecting a transient signal in the power grid signal. Then, in response to detecting the transient signal, blocking input to the signal filter during a transient decay time and, after the transient decay time, stopping said blocking. According to this approach, the damage imposed on acquired data by the transient can advantageously be limited.

The blocking of the input may be initiated after some minimum duration, in some examples. By making transient detection only react for transient longer than a minimum duration, overly sensitive detection can be avoided. The input to the signal filter may then be delayed by an amount equal to or longer than this minimum duration such that transients can be reliably detected and blocked before without being input into the signal filter.

The accuracy of the determined characteristics may be improved as part of an iterative feedback process. That is, the method may further comprise determining a signal quality of the sample signal, and adjusting the probe signal based on the determined quality of the sample signal. As an addition or alternative to determining a signal quality of the sample signal, the signal quality of the component may be determined. Furthermore, instead of, or as well as, adjusting the probe signal, the bandwidth of the filter (e.g. the sample time of an FFT) may be adjusted.

Determining a signal quality of the sample signal may comprise determining a signal-to-noise ratio for the sample signal, determining an uncertainty in the determined one or more characteristics, and/or some other signal processing means used to determine signal quality. Adjusting the probe signal based on the determined quality of the sample signal may comprise adjusting the injection frequency such that the injection frequency is more spaced from the frequency of interest (i.e. increasing the frequency delta), adjusting the amplitude of the probe signal (preferably staying within a prescribed threshold), and/or changing a bandwidth of the injected probe signal (i.e. in frequency space).

By implementing a feedback loop in this way, the resolvability of the sample signal can be advantageously maintained, thus allowing for a continuous monitoring of grid characteristics with minimal oversight. That is, grid characteristics can be output on a near-real-time basis, and the system can dynamically adjust qualities of the probe signal and/or signal filter with a view to optimizing the quality of the grid data or minimizing the impact on the power grid.

Viewed from an aspect, there is provided a power grid system for monitoring characteristics of a power grid.

The power grid system comprises a grid-connected power apparatus configured to inject power signals into a power grid, such as a power converter, and a controller configured to control the power apparatus. The controller may be configured to carry out the aforementioned method. For example, the controller may comprise a data processing device such as a computer that is loaded with a computer-readable medium comprising instructions which, when executed by the computer, causes the controller to carry out the previously described method.

Power converters are often used for providing active and/or reactive electrical power from an electrical generation source to a power grid. A controller may control the operation of switches in power converters in such a way as to generate an AC waveform suitable as a power grid signal (i.e. appropriate voltage, current, and frequency). Thus, in order to inject probe signals into the grid, the controller superimposes the probe signal over the power grid control signal for the power converter(s).

Power converters may generate some internal noise when providing power to the power grid, as part of their normal operation, typically caused to a large degree by converter modulation. This may be referred to as 'converter harmonics'. Therefore, at high frequencies (e.g. 2 kHz or higher), where injection of probe signals may be more challenging, the converter harmonics can be treated as a pseudo-probe signal, the response to which can be extracted in a similar manner as previously described to determine characteristics of the power grid for this high-frequency domain.

In light of the forgoing, it is seen that the injection of low-amplitude probe signals is facilitated by injecting said probe signals at an injection frequency that is different from a frequency of interest, corresponding to a component of the power grid signal that is under investigation.

The response to the injected probe signal, in the form of a so-called sample signal, can be extracted by a signal filter having a filter bandwidth. This is because the relationship between the filter bandwidth and the chosen injection frequency is calibrated in such a manner that allows for the resolution of the sample signal (responding to the injected probe signal according to characteristics of the grid) from the component signal.

Thus, a constant or near-constant probe signal may be injected into the grid for essentially real-time grid monitoring information, without causing disturbances that would be troublesome or even detectable for a customer of the power grid. With such monitoring, the health of the grid can be better understood and maintained.

As a consequence, when viewing the present invention from one perspective, the present technique allows for an improvement in monitoring and maintaining an electrical power grid.

## BRIEF DESCRIPTION OF THE FIGURES

One or more embodiments will be described, by way of example only, and with reference to the following figures, in which:

Figure 1 schematically shows a method for determining characteristics of a power grid, according to an embodiment;

Figure 2 diagrammatically illustrates a power grid signal, according to some embodiments;

Figure 3 diagrammatically illustrates a characteristic of a power grid, according to some embodiments;

Figure 4A diagrammatically illustrates a power grid signal represented with FFT bins, according to an embodiment;

Figure 4B shows an example table of possible injection frequencies, according to an embodiment;

Figures 5A to 5C show a pair of sample signals around a frequency of interest with different FFT bandwidths, according to some embodiments;

Figure 6 schematically shows a power grid system, according to an embodiment;

Figure 7 schematically shows an example implementation of a power grid system; and

Figure 8 schematically shows a data processing device, a computer readable medium, and a computer program product, according to some embodiments.

## DETAILED DESCRIPTION

The present invention is described in the following by way of a number of illustrative examples. It will be appreciated that these examples are provided for illustration and explanation only and are not intended to be limiting on the scope of the present invention. Instead, the scope of the present invention is to be defined by the appended claims. Furthermore, although the examples may be presented in the form of individual embodiments, it will be recognized that the invention also covers combinations of the embodiments described herein.

Any reference to prior art documents or comparative examples in this specification is not to be considered as an admission that such prior art is widely known or forms part of the common general knowledge in the field.

As used in this specification, the words "comprise", "comprising", and similar words are not to be interpreted in the exclusive or exhaustive sense. In other words, they are intended to mean "including, but not limited to".

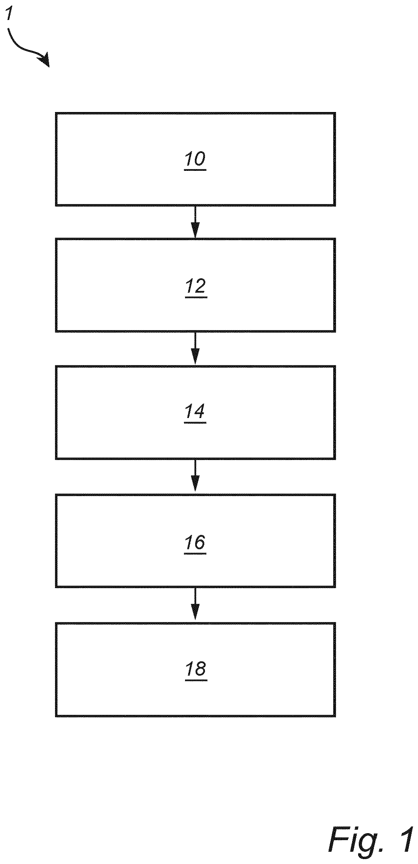

Figure 1 schematically shows a method 1 for determining characteristics of a power grid, according to an embodiment.

According to the illustrated method 1, the method comprises determining 10 a signal filter for extracting a sample signal from a power grid signal. The determining 10 may be based on a number of possible factors. For example, the signal filter may have some associated response time, and the signal filter for extracting the sample signal may be chosen on the basis of some minimum or maximum response time.

In some examples, the signal filter may be a digital filter having a central frequency and a filter bandwidth, such that contributions in an input signal lying outside of this filter bandwidth (i.e., in frequency space) are filtered or attenuated. There may be an inverse relationship between the digital filter's filter bandwidth and its response time. Thus, if a long response time is unacceptable, a larger filter bandwidth can be selected, and vice versa.

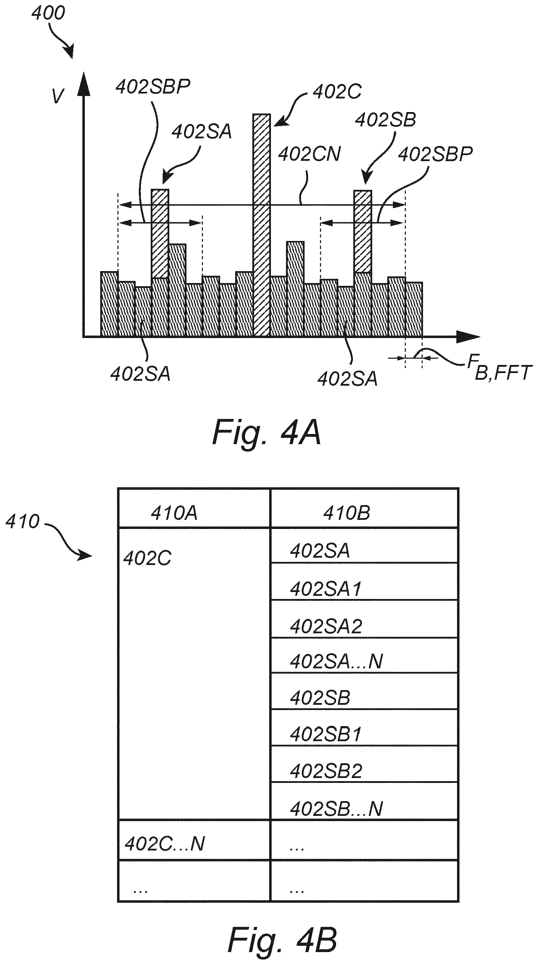

The signal filter may alternatively be a fast-Fourier transform (FFT) applied to the power grid signal. A FFT converts an input power grid signal from its original time domain to a frequency domain, such that the various contributing frequency components in the power grid signal can be distinguished. An FFT may have a range of sample times, analogous to the response time of the digital filter, whereby an increased sample time of an FFT reduces the width of a sampling bin in frequency space (see, e.g. figure 4A as discussed below), thus increasing the resolution of the output signal in frequency space. An FFT may also use a variety of different window shapes, such as rectangular, flat-top, Gaussian, Hanning, etc.

When monitoring a power grid, it may be desired to obtain results regularly. Thus, a limiting factor in respect of the determining 10 of the signal filter may be a maximum acceptable delay, which may correspond to a maximum acceptable response time/sample time of the signal filter.

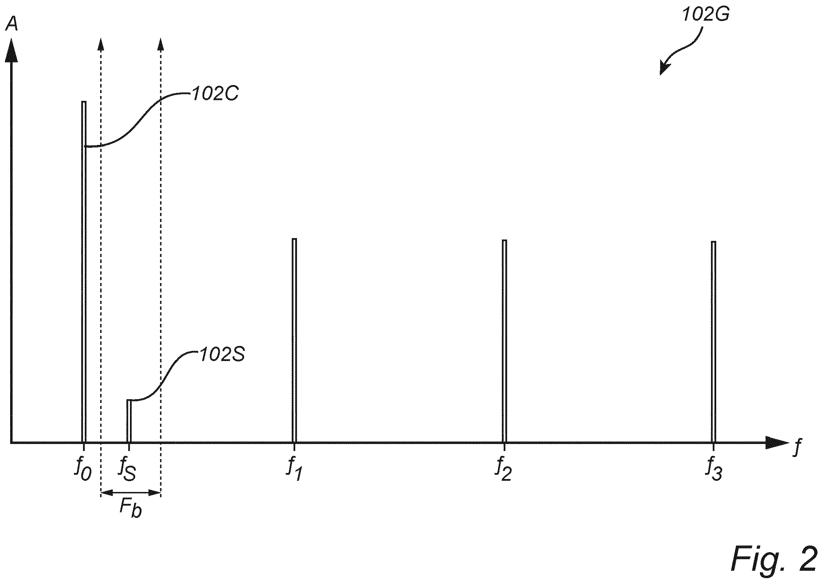

Figure 2 diagrammatically illustrates a power grid signal 102G in frequency ($f$) space, the power grid signal 102G having a fundamental frequency at $f_0$ and harmonics at $f_1$, $f_2$, $f_3$... and so on. The amplitude A is shown on the $y$-axis, which may be representative of a relative voltage, or current, of signals that comprise the power grid signal 102G.

The sample signal 102S to be extracted from the power grid signal 102G may be spaced from the component signal 102C, which in this illustrated example is the fundamental component signal at $f_0$. Thus, in this example, the frequency of interest is $f_0$.

The signal filter may have a bandwidth $F_b$ for extracting the sample signal 102S from the power grid signal 102G in the sense that the bandwidth $F_b$ is selected to exclude the component signal 102C whilst extracting the sample signal 102S.

Considering the distance from the component signal 102C to the sample signal 102S to be $f_s - f_0 = \Delta f$, which may be referred to as a frequency delta, it may be required that $F_B < \frac{1}{2}\Delta f$ in a case where the signal filter is centered on the sample signal 102S.

The method 1 may further comprise generating 12 a probe signal for injecting into the power grid to investigate a component of the power grid signal at a frequency of interest, the probe signal having an injection frequency different to the frequency of interest.

A probe signal may be generated 12 by any suitable signal generation means implemented in hardware and/or software. The probe signal may be thought of as a sinusoidal signal having an amplitude and a frequency. In preferred embodiments, the frequency of the generated 12 sample signal is substantially fixed. The amplitude may be represented in terms of voltage, and can be represented in respect of a proportion of the main voltage signal of the power grid signal.

For example, for a power grid signal having a fundamental frequency of 50 Hz, a main input signal contributed to the grid from a power substation may be 100 kV, for example. Thus, in this example, 100 kV can be represented as 1 pu, or 'per unit'. Thus, a signal having an amplitude of 1 kV may be said to be a 0.01 pu signal. In such an example, it may be expected for harmonic components (i.e. multiples of the fundamental frequency present in the power grid signal due to wave physics) to have a strength/amplitude of ~250 V, or 0.0025 pu, possibly up to, for example, 0.03 pu. In commercial power grids, a customer may request that inter-harmonic interference is kept below 0.001 pu.

According to this generating step 12, the injection frequency may be spaced from the frequency of interest such that the sample signal is resolvable, using the determined signal filter, from the component of the power grid signal, where the sample signal responds to the probe signal according to the one or more characteristics of the power grid at the frequency of interest.

In an example that employs a digital filter, this may involve spacing the injection frequency from the frequency of interest (i.e. the frequency $f_0$ of the component signal 102C in figure 2) far enough away that the filter bandwidth may span the injection frequency whilst substantially rejecting the contributions from the component signal at the frequency of interest, which may be much greater in magnitude than the sample signal being extracted, for example as shown in figure 2.

Similarly, in an example that employs an FFT, this may involve setting the sample time to be large enough such that the frequency bins are small enough to clearly distinguish the sample signal, in frequency space, from the component signal in the power grid signal.

In this way, a very low amplitude injection signal can be used, e.g. 0.0002 pu, which may be well below a detectable threshold for customers. Thus, the present approach may be referred to as 'stealth grid diagnosis'.

Accordingly, the method 1 further comprises injecting 14 the probe signal into the power grid, extracting 16 the sample signal from the power grid signal using the signal filter, and determining 18 the one or more characteristics of the power grid at the frequency of interest based on the sample signal.

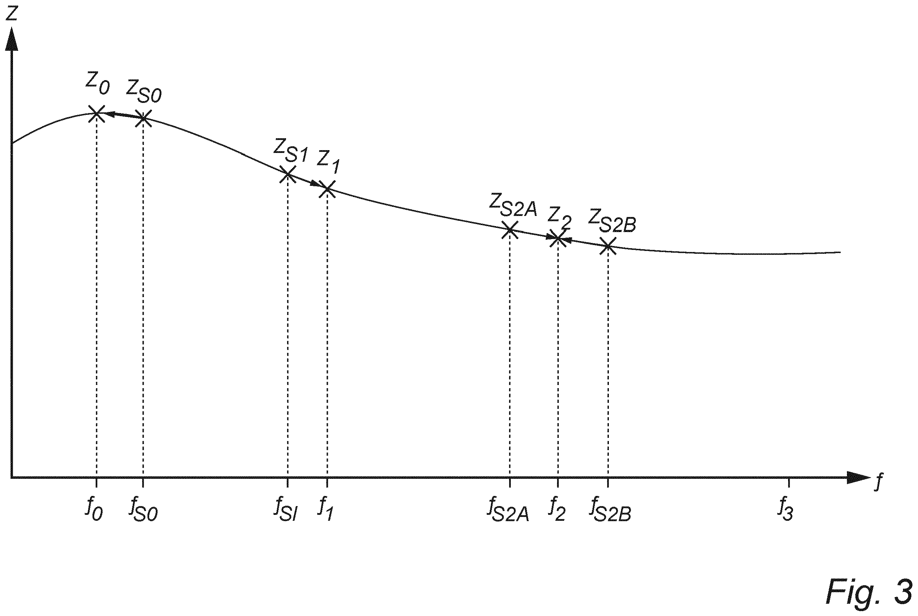

The one or more characteristics may, for example, include impedance $Z$ of the power grid for one or various interesting frequencies, as illustrated diagrammatically in figure 3.

Typically, characteristics such as impedance $Z$ are smoothly and/or gradually varying with frequency. That is, for small $\Delta f$ (e.g. < 10 Hz, < 5 Hz, or < 2 Hz depending on the particular characteristic or the particular power grid), it can be taken that $Z_f \ll Z_{f+\Delta f}$.

Thus, determining 18 the one or more characteristics of the power grid at the frequency of interest $f_0$ may comprise determining the one or more characteristics of the power grid at the injection frequency $f_{so}$. That is, the sample signal will be present in the power grid signal at the injection frequency $f_{so}$ as a response to the injected probe signal that was generated to investigate characteristics of the power grid at $f_0$.

The extracted sample signal will be a response to the injected sample signal according to characteristics of the power grid at the injection frequency. The extracted sample signal may, for example, comprise a measured voltage signal $Vs$ and a measured current signal $7s$. Impedance may be determined as $Z_S = V_S/I_S$. A high impedance at the injection frequency may cause a response in the form of a sample signal at the injection frequency that has a relatively lower $Is$ and vice versa.

In some examples, determining 18 the one or more characteristics of the power grid at the frequency of interest $f_0$ may comprise determining the one or more characteristics of the power grid at the injection frequency $f_{so}$ and extrapolating from the injection frequency $f_{so}$ to the corresponding frequency of interest $f_0$, as indicated by the arrow from $Z_{so}$ to $Z_o$.

As shown in figure 3, multiple components may be investigated, such that characteristics are determined for a plurality of frequencies: $f_0$, $f_1$, and $f_2$. For each component under investigation, one or more probe signals may be generated.

Whilst for the component at $f_0$, the injection frequency $f_{S0}$ is spaced from the frequency of interest $f_0$ by a positive frequency delta, the frequency delta may also be negative. That is, with reference to the component at $f_1$, the injection frequency $f_{S1}$ may be determined for the probe signal such that it is at a lesser frequency than the frequency of interest $f_1$. The value for $Z_1$ may then be

determined by extrapolation from $Z_{S1}$, as indicated by the arrow from $Z_{S1}$ to $Z_1$.

The characteristic for the power grid at a frequency of interest may also be determined using interpolation, in which case two or more probe signals may be generated, at injections frequencies that are respectively lesser and greater than the frequency of interest.

An example of such a technique is shown in relation to the component at frequency $f_2$. A pair of probe signals are generated to have respective injection frequencies $f_{S2A} < f_2$ and $f_{S2B} > f_2$. The respective frequency deltas between the injection frequencies and the frequency of interest may be the same, or different, depending on the implementation. For example, as discussed in more detail below, a possible injection neighborhood may be scanned for an optimum injection frequency for each injected probe signal.

When using multiple probe signals, thereby inducing multiple responding sample signals corresponding thereto, an interpolation may be carried out as shown in figure 3. That is, for example, a value for $Z_2$ may be determined based on an interpolation between values for $Z_{S2A}$ and $Zsza$, as indicated by the arrows.

Figure 4A diagrammatically illustrates a power grid signal 400 represented with FFT bins having width $F_{B,FFT}$ which may be 1 Hz, 2 Hz, or more or less, depending on the sample time of the FFT. According to the illustrated example, the component signal 402C is under investigation using two probe signals, producing two sample signals 402SA, 402SB resolvable in the FFT representation. It will be appreciated that a broader bin size for the FFT (e.g. 5 times the width) may risk contributions from the component signal 402C being included in the same bin as the sample signal(s) 402SA, 402SB.

When extracting the sample signals from an FFT such as that shown in figure 4A, the bins identified as containing the sample signal can be extracted from the FFT. That is, the amplitude (voltage value and/or current value etc.) of these bins may represent the sample signal. In some examples, a contribution from noise may be estimated and removed from the extracted sample signals.

In some examples, the component signal 402C may be identified in the power signal by comparing the amplitude of bins (e.g. a measured voltage value averaged over the frequency span of a bin) against a predetermined, or dynamically determined, component threshold. For example, it may be assumed that any bin exceeding 0.002 pu contains a harmonic component.

Additionally or alternatively, the anticipated location of harmonic components may be included into the identification of harmonic components in the power grid signal. For example, if the fundamental frequency of the power grid signal is known or measured, harmonic components may be expected at frequencies which are multiples of the fundamental frequencies. Thus, a search for component signals may be confined to neighborhoods of such multiples (e.g. within 5 Hz, 10 Hz, 20 Hz, or less or more).

The power grid signal may contain a base level of noise caused by loads on the power grids, modulation of power converters that feed the grid, and/or other factors. This noise is represented in figure 4A as lighter colored low-amplitude contributions. To give an example, an expected or tolerated level of noise may be -0.00005 pu, or more or less depending on the resolution of the FFT (as discussed more below). Thus, an injected probe signal may preferably have an amplitude that is large enough to distinguish from noise, whilst not exceeding a customer's maximum tolerated level of interference. Continuing the previous example, this may allow a range for injection of from 0.0001 to 0.001 pu.

As shown in figure 4A, the amount of noise/disturbance in the power grid signal may vary with frequency. Thus, in order to optimize probe signal injection, it may be preferred to determine an injection frequency based at least in part on an amount of disturbance around the component. Furthermore, if a plurality of components of the power grid signal may be used for investigating characteristics, the component having the least associated disturbance may be selected.

According to some examples, the component 402C may be selected, at a frequency of interest. This selection may be based on a determined amount of disturbance in the neighborhood 402CN of the component signal 402C (in frequency space).

As previously discussed, an injection frequency may then be determined for each probe signal 402SA, 402SB to be injected into the power grid. There may be a range of acceptable frequencies for injecting the probe signals 402SA, 402SB. As previously discussed, limitations on such a range may include a filter bandwidth of the signal filter (i.e., in this case, the bin resolution $F_{B,FFT}$ of the FFT), a preferred accuracy for extrapolation/interpolation, the proximity of neighboring components, and/or other factors.

Possible ranges for the injection frequencies may be determined, as shown in figure 4A as ranges 402SAP, 402SBP. In this example, each range 402SAP, 402SBP spans 5 frequency bins. The amount of noise/disturbance in each bin may be determined, and the injection frequency for the probe signal 402SA, 402SB may be determined based on the frequency (central or otherwise) of the bin in the possible injection range 402SAP, 402SBP having the least disturbance.

In some examples, a table 410 may be populated and maintained, such as that shown in figure 4B. For example, there may be a column 410A for each component and a column for possible injection frequencies 410B. The table may be populated with metrics according to the determined disturbance at each possible injection frequency, and/or the possible injection frequencies may be ranked according to an amount of noise/disturbance.

The table 410 may be dynamically maintained. For example, column 410A may be populated with identified components 402C... 402CN, whereby components may be classified according to a bin exceeding the component threshold, for example, as discussed above, or by some other suitable method.

For each identified component, a corresponding neighborhood may be identified therearound. Within said neighborhood, possible ranges for injection frequencies may be determined according to each probe signal to be injected. Thus, the column 410B of the table 410 may be populated accordingly.

Based on the populated table 410, injection frequencies for each probe signal to be injected may be determined, preferably selecting the candidate injection frequency (i.e. bin) with the least noise/disturbance - i.e., the preferred bins 402SAPref. and 402SBPref. as shown in figure 4A.

In some examples, the selection of injection frequencies may only occur once, at the time of first injecting the probe signal(s) into the power grid. In other examples, injection frequencies may be updated as part of a feedback loop.

The feedback loop may be configured to update/reassess after a predetermined amount of time, or in response to a command. For example, an amount of disturbance in the presently selected bin for an injection frequency may be monitored, and a command to determine a new injection frequency for a probe signal may be generated in response to the disturbance in the presently selected bin exceeding a threshold. Additionally or alternatively, an error in the calculated value for the determined characteristic may be determined, and a command to determine a new injection frequency for a probe signal may be generated in response to the error exceeding a threshold.

Further feedback loops may be incorporated into the method of operation. For example, the amplitude of the injected probe signal may be adjusted based on similar factors. That is, the amplitude of a probe signal may be increased in response to a determination that there are disturbances at the injection frequency or in the locality thereof. By increasing the amplitude of the probe signal, the resulting sample signal will be more easily distinguishable from the surrounding noise. However, it may be preferable to ensure that the amplitude of the injected probe signal is kept below any prescribed thresholds, as discussed above. The measured amplitude of sample signals may be regularly compared to a desired amplitude, and the amplitude of probe signals may be adjusted accordingly on a dynamic basis.

The filter bandwidth/sample time of the FFT may also be dynamically adjusted. For example, if the sample signal is no longer resolvable due to disturbances/noise, or a shifting frequency of a component signal, and/or any other reason, the resolution of the FFT may be dynamically adjusted, such as increasing the resolution by increasing the sample time.

The sample time may also be decreased if it is determined that such a high resolution is not required to resolve the sample signal, thereby optimizing the balance between sample time and resolution. Furthermore, there may be an upper limit on the preferred resolution for an FFT, as over-resolved noise in the power grid signal may obscure sample signals.

The frequency of a particular component may also change or drift with time. In such cases, the injection signal may be adjusted accordingly. For example, the injection frequency may be updated in such a way to 'track' the changes in the frequency of the component under investigation, thereby substantially maintaining the frequency delta between the component signal and the sample signal(s) and thus advantageously preserving the resolvability of the sample signal(s).

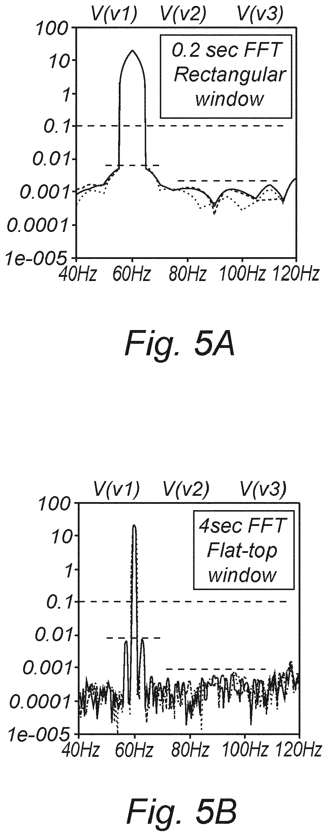

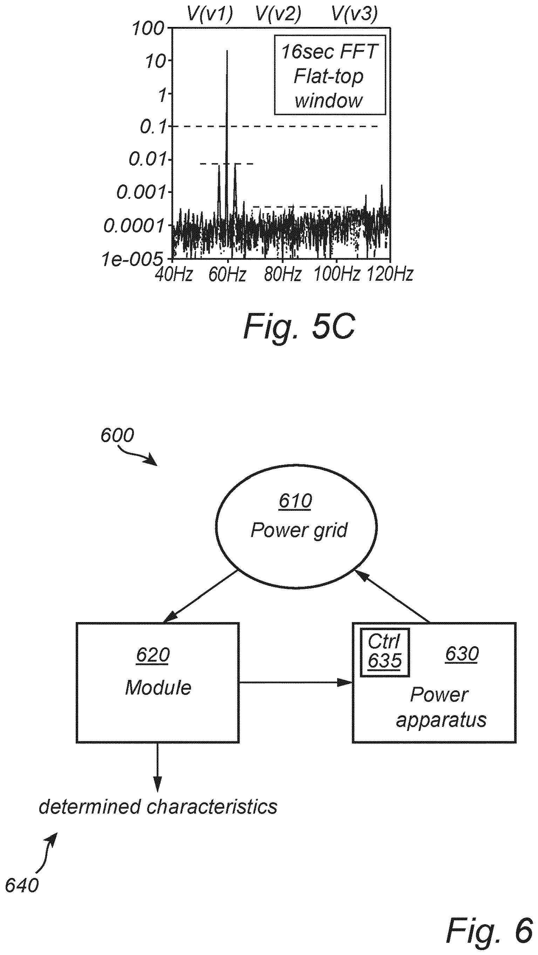

Figures 5A to 5C show example FFTs of a 60 Hz component and a pair of sample signals therearound. Figure 5A shows an FFT having a 0.2 second sample time, using a rectangular window, figure 5B shows an FFT having a 4 second sample time, using a flat-top window, and figure 5C shows an FFT having a 16 second sample time, using a flat-top window. The $y$-scale in these figures is percentage, such that 100% = 1 pu.

As can be seen in these figures, the resolution of the FFTs increases according to the sample time such that, in figure 5A, the sample signals are not resolvable from the 60 Hz component. In figure 5B, the sample signals are more resolved, and in figure 5C, the sample signals are clearly resolved at an amplitude of approximately 0.01%. In these examples, probe signals are injected at 57 Hz and 63 Hz, such that the frequency delta is 3 Hz for both sample signals.

It will be understood that a 3 Hz frequency delta may require at least 0.33... seconds (inverse of 3 Hz) as a sample time for the FFT in order to resolve the sample signals. However, as discussed above, in practice, a greater sample time may be required to account for a bandwidth of the component signal and additional noise in the power grid signal.

It will be appreciated from figures 5A to 5C that the resolution of FFTs, injection frequencies, amplitudes of probe signals, etc. can be optimized according to needs (e.g. a maximum acceptable sample/response time).

An FFT such as that shown in figure 5B may be generated every 4 seconds for a power grid signal, and characteristics may be determined therefrom every 4 seconds according to the techniques discussed above. Thus, a power grid may be constantly monitored using the present techniques without disturbing the power grid signal, i.e. the sample signals having an amplitude of 0.01% may be substantially below a customer's maximum tolerance of -0.1%.

An example power grid system 600 for implementing the above described method is shown in figure 6.

As shown in figure 6, the system 600 may comprise a power grid 610, a power apparatus 630 for providing power to the power grid under the control of a controller 635, and a module 620 for executing the above described method.

The power apparatus 630 may be a power converter, and the controller 635 may comprise a modulator for modulating the converter signal.

As indicated by the arrow between the power apparatus 630 and the power grid 610, the power apparatus 630 may provide power to the power grid 610 according to a power grid control signal, which may be modulated to produce a fundamental grid frequency (e.g. 50 Hz or 60 Hz). The power grid 610 may then distribute the provided power to a number of customers to service the demand of electrical loads.

As indicated by the arrow between the power grid 610 and the module 620, the module may extract a power grid signal from the power grid 610 via one or more connections thereto. In accordance with the previously described method, the module may determine an injection frequency for a probe signal with which to determine one or more characteristics 640 of the power grid 610.

The module 620 may then provide the generated probe signal to the power apparatus 630 (or the controller 635 thereof) such that the generated probe signal can be superimposed over the power grid signal input into the power grid 610 by the power apparatus 630, thereby injecting the probe signal into the power grid.

In some alternative examples, the modulation of the power apparatus 630 (e.g. power converter) by the controller 635 thereof may cause an amount of high-frequency noise, which may serve as a pseudo-probe signal. That is, the module 620 may investigate high frequency (e.g. in the order of a few kHz up to 100 kHz) by extracting sample signals corresponding to the injected high-frequency noise from the power apparatus 630, and determine characteristics of the power grid 610 based thereon.

Such an approach may advantageously allow for investigation of the power grid at higher frequencies, where injecting probe signals may be more difficult.

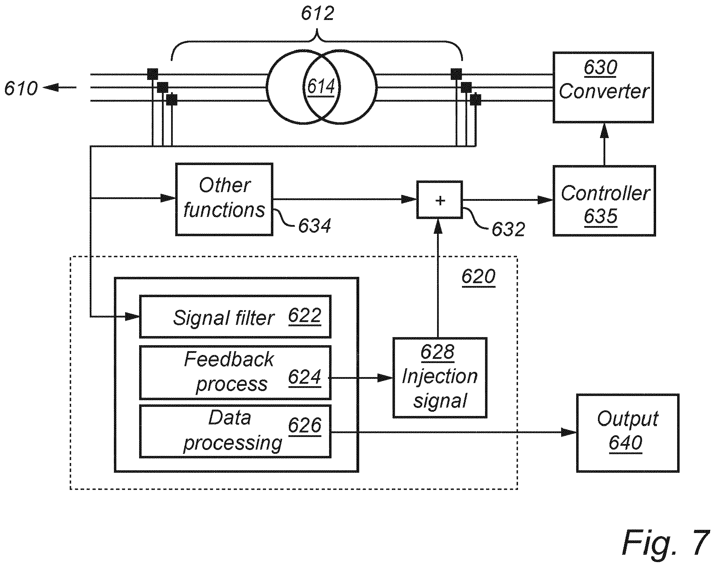

Figure 7 shows a possible implementation of the system 600 into a power substation, according to an embodiment.

According to the illustrated example, the power apparatus is a converter 630 controlled by a controller 635. The converter 630 is connected to the power grid 610 via a transformer 614, and provides a three-phase power signal to the power grid 610.

The module 620 may receive a power grid signal from each phase via connections 612, which may be either side of the transformer 614. It should be noted that signals from the connections 612 may also be used for other functions, such as maintaining a phase-locked loop for controlling the converter 630 to have a frequency matching the prevailing frequency of the power grid 610, for example.

The power grid signal(s) may be input into a signal filter 622 of the module 620, which extracts a sample signal therefrom.

Various feedback processes 624 may also be performed, as mentioned above, to preserve the resolvability of the sample signal, improve the accuracy of the output characteristics 640, etc. Based on an output of these processes, according to the invention, a probe/injection signal 628 is generated and superimposed over a control signal used for controlling the converter 630, for example via an addition junction 632 preceding the controller 635 of the converter.

The probe signal 628 may comprise one or more probe signals generated per phase and/or per component for investigating.

All described software and hardware may be provided in single phase or multi-phase form. For a multi-phase (e.g. three-phase) implementation, phase sequences may also be considered. The frequency components in the injection signal for a frequency of interest can be for positive or negative sequence. In some examples, it may be desired to combine positive phase sequence for certain harmonics/components with negative sequence for others. Alternating between different resulting mixes can be used for broader information collection and also to suit different situations or needs.

A data processing portion 626 of the module 620 may then determine one or more characteristics. For example, a comparator (not shown) may compare an extracted current signal and an extracted voltage signal which comprise the extracted sample signal, and characteristics such as an impedance of the power grid may be determined accordingly and provided as output 640.

Signals acquired for grid voltage and grid current can also be separated into positive and negative sequence contributions such that the impedances for both can be calculated (injection and analysis can also be considered for the zero phase sequence, in some examples).

The module 620 may be implemented in the form of additional hardware, or as a software component of the controller 635, for example.

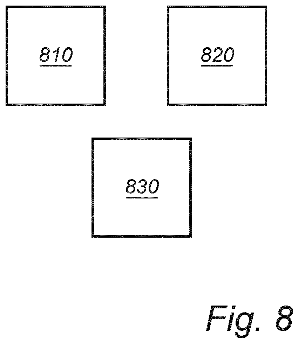

For example, as illustrated in figure 8, the method may be carried out by a data processing device 810.

The method may be encoded into a series of computer executable instructions and stored onto a computer-readable medium 820 such that when the program is executed by a computer, the computer executes the method. The computer-readable medium may be provided as a computer program product 830.

Thus, advantageously, the present method allows for a constant stealth monitoring means for a power grid, which requires minimal hardware additions, if any. That is, the present invention may advantageously be implemented as an entirely software package such that existing power substations and the like can be retrofitted to implement the invention.

Whilst the invention is susceptible to various modifications and alternative forms, specific embodiments are shown by way of example in the drawings as herein described in detail. It should be understood, however, that the detailed description herein and the drawings attached hereto are not intended to limit the invention to the particular form disclosed. Rather, the intention is to cover all modifications and alternatives falling within the scope of the appended claims.

## Claims

1. A computer-implemented method for determining characteristics of a power grid;

    determining a signal filter for extracting a sample signal (102S) from a power grid signal (102G), the signal filter being configured to filter frequencies outside of a filter bandwidth ($F_B$) from the power grid signal;
    generating a probe signal for injecting into the power grid to investigate a component (102C) of the power grid signal at a frequency of interest ($f_0$), the probe signal having an injection frequency ($f_S$) different to the frequency of interest; wherein:

    the injection frequency is spaced from the frequency of interest such that the sample signal is resolvable, using the determined signal filter, from the component of the power grid signal, and
    the sample signal responds to the probe signal according to the one or more characteristics of the power grid at the frequency of interest,

    extracting the sample signal from the power grid signal using the signal filter; and
    determining the one or more characteristics of the power grid at the frequency of interest based on the sample signal, **characterized in that** the probe signal is injected into the power grid by superimposing the probe signal over a grid control signal for a grid-connected power converter.

2. The computer-implemented method according to claim 1, wherein:
    the signal filter is a digital filter or a fast-Fourier transform (FFT).

3. The computer-implemented method according to claim 1 or claim 2, wherein:
    determining the one or more characteristics of the power grid at the frequency of interest based on the sample signal comprises:

    determining the one or more characteristics of the power grid at the injection frequency based on the sample signal; and
    extrapolating from the injection frequency to the frequency of interest.

4. The computer-implemented method according to any preceding claim, further comprising:

    obtaining an amplitude threshold corresponding to a maximum tolerance for grid disturbance;
    wherein generating the probe signal comprises: generating the probe signal with an amplitude less than or equal to the amplitude threshold.

5. The computer-implemented method according to any preceding claim, further comprising:
    generating a plurality of probe signals for injecting into the power grid to investigate a respective plurality of components of the power grid signal at a respective plurality of frequencies of interest, each probe signal having a respective injection frequency.

6. The computer-implemented method of any preceding claim, wherein:

    the probe signal or at least one of the plurality of probe signals comprises a pair of probe signals;
    a first probe signal of the pair of probe signals has a first injection frequency greater than the frequency of interest and a second probe signal of the pair of probe signals has a second injection frequency less than the frequency of interest; and
    determining the one or more characteristics of the power grid at the frequency of interest based on the sample signal comprises:

    determining the one or more characteristics of the power grid at the first injection frequency based on a first sample signal responding to the first probe signal;
    determining the one or more characteristics of the power grid at the second injection frequency based on a second sample signal responding to the second probe signal; and
    interpolating between the first injection frequency and the second injection frequency to the frequency of interest.

7. The computer-implemented method of any preceding claim, further comprising:

    determining a signal quality of the sample signal; and
    adjusting the probe signal based on the determined quality of the sample signal.

8. The computer-implemented method of claim 7, wherein:

    determining a signal quality of the sample signal comprises:

determining a signal-to-noise ratio for the sample signal, or
determining an uncertainty in the determined one or more characteristics; and

adjusting the probe signal based on the determined quality of the sample signal comprises:

adjusting the injection frequency such that the injection frequency is more spaced from the frequency of interest, or
adjusting the amplitude of the probe signal.

9. The computer-implemented method of any preceding claim, wherein:

the injection frequency is spaced from the frequency of interest by a frequency delta; and
the frequency delta is maintained such that the injection frequency tracks changes in the frequency of the component from the frequency of interest.

10. The computer implemented method according to any preceding claim, further comprising:

identifying a plurality of components of the power grid signal;
determining a signal quality of each of the plurality of components; and
selecting the component from the plurality of components based on the component having the greatest signal quality.

11. The computer implemented method according to any preceding claim, further comprising:

detecting a transient signal in the power grid signal;
in response to detecting the transient signal, blocking input to the signal filter during a transient decay time; and
after the transient decay time, stopping said blocking.

12. The computer implemented method according to any preceding claim, wherein:

the power grid signal comprises a plurality of phases; and
generating the probe signal comprises generating a respective probe signal for each of the plurality of phases.

13. The computer-implemented method according to claim 12, wherein:
the probe signal comprises a positive phase sequence and/or a negative phase sequence.

14. A data processing device configured to carry out the method of any of claims 1 to 13.

15. A computer program product comprising instructions which, when the program is executed by a computer, cause the computer to carry out the method of any of claims 1 to 13.

16. A computer-readable medium comprising instructions which, when executed by a computer, cause the computer to carry out the method of any of claims 1 to 13.

17. A power grid system comprising:

a grid-connected power converter configured to provide reactive and/or active power to the power grid according to a power grid control signal, and inject power signals into the power grid by superimposing the injected signal over the power grid control; and
a controller configured to control the power converter;
wherein the power converter comprises the data processing device of claim 14.

**Patentansprüche**

1. Computerimplementiertes Verfahren zum Bestimmen der Eigenschaften eines Stromnetzes;

Bestimmen eines Signalfilters zum Extrahieren eines Abtastsignals (102S) aus einem Stromnetzsignal (102G), wobei das Signalfilter dazu ausgelegt ist, Frequenzen außerhalb einer Filterbandbreite ($F_B$) aus dem Stromnetzsignal zu filtern;
Erzeugen eines Sondensignals zum Einspeisen in das Stromnetz, um eine Komponente (102C) des Stromnetzsignals bei einer interessierenden Frequenz ($f_0$) zu untersuchen, wobei das Sondensignal eine Einspeisefrequenz ($f_S$) hat, die sich von der interessierenden Frequenz unterscheidet; wobei:

die Einspeisefrequenz von der interessierenden Frequenz so beabstandet ist, dass das Abtastsignal unter Verwendung des bestimmten Signalfilters von der Komponente des Stromnetzsignals auflösbar ist, und
das Abtastsignal auf das Sondensignal gemäß der einen oder mehreren Eigenschaften des Stromnetzes bei der interessierenden Frequenz reagiert, Extrahieren des Abtastsignals unter Verwendung des Signalfilters aus dem Stromnetzsignal; und
Bestimmen der einen oder mehreren Eigenschaften des Stromnetzes bei der interessierenden Frequenz basierend auf dem Abtastsignal, **dadurch gekennzeichnet, dass** das Sondensignal durch Überlagern des Sondensignals mit einem Netzsteuersignal für einen netzgekoppelten Stromrichter in das Stromnetz eingespeist wird.

2. Computerimplementiertes Verfahren nach Anspruch 1, wobei:
das Signalfilter ein digitales Filter oder eine Fast-Fourier-Transformation (FFT) ist.

3. Computerimplementiertes Verfahren nach Anspruch 1 oder Anspruch 2, wobei:
das Bestimmen der einen oder mehreren Eigenschaften des Stromnetzes bei der interessierenden Frequenz basierend auf dem Abtastsignal umfasst:

Bestimmen der einen oder mehreren Eigenschaften des Stromnetzes bei der Einspeisefrequenz basierend auf dem Abtastsignal; und
Extrapolieren von der Einspeisefrequenz auf die interessierende Frequenz.

4. Computerimplementiertes Verfahren nach einem der vorhergehenden Ansprüche, das ferner umfasst:

Erhalten einer Amplitudenschwelle, die einer maximalen Toleranz für Netzstörungen entspricht;
wobei das Erzeugen des Sondensignals umfasst:
Erzeugen des Sondensignals mit einer Amplitude, die kleiner oder gleich der Amplitudenschwelle ist.

5. Computerimplementiertes Verfahren nach einem der vorhergehenden Ansprüche, das ferner umfasst:
Erzeugen einer Mehrzahl von Sondensignalen zum Einspeisen in das Stromnetz, um eine jeweilige Mehrzahl von Komponenten des Stromnetzsignals bei einer jeweiligen Mehrzahl von interessierenden Frequenzen zu untersuchen, wobei jedes Sondensignal eine jeweilige Einspeisefrequenz aufweist.

6. Computerimplementiertes Verfahren nach einem der vorhergehenden Ansprüche, wobei:

das Sondensignal oder zumindest eines der Mehrzahl von Sondensignalen ein Paar von Sondensignalen umfasst;
ein erstes Sondensignal des Paares von Sondensignalen eine erste Einspeisefrequenz hat, die größer als die interessierende Frequenz ist, und ein zweites Sondensignal des Paares von Sondensignalen eine zweite Einspeisefrequenz hat, die kleiner als die interessierende Frequenz ist; und
das Bestimmen der einen oder mehreren Eigenschaften des Stromnetzes bei der interessierenden Frequenz basierend auf dem Abtastsignal umfasst:

Bestimmen der einen oder mehreren Eigenschaften des Stromnetzes bei der ersten Einspeisefrequenz basierend auf einem ersten Abtastsignal, das auf das erste Sondensignal reagiert;
Bestimmen der einen oder mehreren Eigenschaften des Stromnetzes bei der zweiten Einspeisefrequenz basierend auf einem zweiten Abtastsignal, das auf das zweite Sondensignal reagiert; und
Interpolieren zwischen der ersten Einspeisefrequenz und der zweiten Einspeisefrequenz auf die interessierende Frequenz.

7. Computerimplementiertes Verfahren nach einem der vorhergehenden Ansprüche, das ferner umfasst:

Bestimmen einer Signalqualität des Abtastsignals; und
Anpassen des Sondensignals basierend auf der bestimmten Qualität des Abtastsignals.

8. Computerimplementiertes Verfahren nach Anspruch 7, wobei:
das Bestimmen einer Signalqualität des Abtastsignals umfasst:

Bestimmen eines Signal-Rausch-Verhältnisses für das Abtastsignal, oder
Bestimmen einer Unsicherheit in dem bestimmten einen oder mehreren Eigenschaften; und
das Anpassen des Sondensignals basierend auf der bestimmten Qualität des Abtastsignals umfasst:

Anpassen der Einspeisefrequenz, so dass die Einspeisefrequenz weiter von der interessierenden Frequenz beabstandet ist, oder
Anpassen der Amplitude des Sondensignals.

9. Computerimplementiertes Verfahren nach einem der vorhergehenden Ansprüche, wobei:

die Einspeisefrequenz von der interessierenden Frequenz um ein Frequenzdelta beabstandet ist; und
das Frequenzdelta so aufrechterhalten wird, dass die Einspeisefrequenz Veränderungen in der Frequenz der Komponente gegenüber der interessierenden Frequenz verfolgt.

**10.** Computerimplementiertes Verfahren nach einem der vorhergehenden Ansprüche, das ferner umfasst:

Identifizieren einer Mehrzahl von Komponenten des Stromnetzsignals;
Bestimmen einer Signalqualität für jede der Mehrzahl von Komponenten; und
Auswählen der Komponente aus der Mehrzahl der Komponenten basierend auf der Komponente mit der höchsten Signalqualität.

**11.** Computerimplementiertes Verfahren nach einem der vorhergehenden Ansprüche, das ferner umfasst:

Erkennen eines transienten Signals im Stromnetzsignal;
als Reaktion auf das Erkennen des transienten Signals, Sperren des Eingangs zu dem Signalfilter während einer transienten Abklingzeit; und
nach der transienten Abklingzeit, Aufheben des Blockierens.

**12.** Computerimplementiertes Verfahren nach einem der vorhergehenden Ansprüche, wobei:

das Stromnetzsignal eine Mehrzahl von Phasen umfasst; und
das Erzeugen des Sondensignals das Erzeugen eines jeweiligen Sondensignals für jede der Mehrzahl von Phasen umfasst.

**13.** Computerimplementiertes Verfahren nach Anspruch 12, wobei:
das Sondensignal eine positive Phasenfolge und/oder eine negative Phasenfolge umfasst.

**14.** Datenverarbeitungsvorrichtung, die dazu ausgelegt ist, das Verfahren nach einem der Ansprüche 1 bis 13 durchzuführen.

**15.** Computerprogrammprodukt, das Anweisungen umfasst, die, wenn das Programm von einem Computer ausgeführt wird, den Computer veranlassen, das Verfahren nach einem der Ansprüche 1 bis 13 durchzuführen.

**16.** Computerlesbares Medium, das Anweisungen umfasst, die, wenn sie von einem Computer ausgeführt wird, den Computer veranlassen, das Verfahren nach einem der Ansprüche 1 bis 13 durchzuführen.

**17.** Stromnetzsystem, xxumfassend:

einen netzgekoppelten Stromrichter, der dazu ausgelegt ist, dem Stromnetz entsprechend einem Stromnetz-Steuersignal Blind- und/oder Wirkleistung bereitzustellen und Leistungssignale durch Überlagern des eingespeisten Signals mit der Stromnetzsteuerung in das Stromnetz einzuspeisen; und
eine Steuerung, die dazu ausgelegt ist, den Stromrichter zu steuern;
wobei der Stromrichter die Datenverarbeitungsvorrichtung nach Anspruch 14 umfasst.

**Revendications**

**1.** Procédé mis en œuvre par ordinateur pour la détermination de caractéristiques d'un réseau électrique ;

la détermination d'un filtre de signal pour extraire un signal d'échantillon (102S) provenant d'un signal de réseau électrique (102G), le filtre de signal étant configuré pour filtrer des fréquences en dehors d'une largeur de bande de filtre ($F_B$) du signal de réseau électrique ;
la génération d'un signal de sonde pour l'injecter dans le réseau électrique pour examiner une composante (102C) du signal de réseau électrique à une fréquence d'intérêt ($f_0$), le signal de sonde ayant une fréquence d'injection ($f_S$) différente de la fréquence d'intérêt ;
la fréquence d'injection étant espacée de la fréquence d'intérêt de telle sorte que le signal d'échantillon est résoluble, en utilisant le filtre de signal déterminé, à partir de la composante du signal de réseau électrique, et
le signal d'échantillon répondant au signal de sonde selon les une ou plusieurs caractéristiques du réseau électrique à la fréquence d'intérêt, extrayant le signal d'échantillon du signal de réseau électrique en utilisant le filtre de signal ; et
la détermination des une ou plusieurs caractéristiques du réseau électrique à la fréquence d'intérêt étant basée sur le signal d'échantillon, **caractérisé en ce que**
le signal de sonde est injecté dans le réseau électrique en superposant le signal de sonde sur un signal de commande de réseau pour un convertisseur de puissance connecté au réseau.

**2.** Procédé mis en œuvre par ordinateur selon la revendication 1,
le filtre de signal étant un filtre numérique ou une transformée de Fourier rapide (FFT).

**3.** Procédé mis en œuvre par ordinateur selon la revendication 1 ou la revendication 2,
la détermination des une ou plusieurs caractéristiques du réseau électrique à la fréquence d'intérêt basée sur le signal d'échantillon comprenant :

la détermination des une ou plusieurs caractéristiques du réseau électrique à la fréquence d'injection basée sur le signal d'échantillon ; et l'extrapolation de la fréquence d'injection à la fréquence d'intérêt.

4. Procédé mis en œuvre par ordinateur selon l'une quelconque des revendications précédentes, comprenant en outre :

l'obtention d'un seuil d'amplitude correspondant à une tolérance maximale pour une perturbation de réseau ;
la génération du signal de sonde comprenant :
la génération du signal de sonde avec une amplitude inférieure ou égale au seuil d'amplitude.

5. Procédé mis en œuvre par ordinateur selon l'une quelconque des revendications précédentes, comprenant en outre :
la génération d'une pluralité de signaux de sonde pour les injecter dans le réseau électrique pour examiner une pluralité respective de composantes du signal de réseau électrique à une pluralité respective de fréquences d'intérêt, chaque signal de sonde ayant une fréquence d'injection respective.

6. Procédé mis en œuvre par ordinateur selon l'une quelconque des revendications précédentes,

le signal de sonde ou au moins un de la pluralité de signaux de sonde comprenant une paire de signaux de sonde ;
un premier signal de sonde de la paire de signaux de sonde ayant une première fréquence d'injection supérieure à la fréquence d'intérêt et un deuxième signal de sonde de la paire de signaux de sonde ayant une deuxième fréquence d'injection inférieure à la fréquence d'intérêt ; et
la détermination des une ou plusieurs caractéristiques du réseau électrique à la fréquence d'intérêt basée sur le signal d'échantillon comprenant :

la détermination des une ou plusieurs caractéristiques du réseau électrique à la première fréquence d'injection basée sur un premier signal d'échantillon répondant au premier signal de sonde ;
la détermination des une ou plusieurs caractéristiques du réseau électrique à la deuxième fréquence d'injection basée sur un deuxième signal d'échantillon répondant au deuxième signal de sonde ; et
l'interpolation entre la première fréquence d'injection et la deuxième fréquence d'injection à la fréquence d'intérêt.

7. Procédé mis en œuvre par ordinateur selon l'une quelconque des revendications précédentes, comprenant en outre :

la détermination d'une qualité de signal du signal d'échantillon ; et
l'ajustement du signal de sonde sur la base de la qualité déterminée du signal d'échantillon.

8. Procédé mis en œuvre par ordinateur selon la revendication 7,
la détermination d'une qualité de signal du signal d'échantillon comprenant :

la détermination d'un rapport signal sur bruit pour le signal d'échantillon, ou
la détermination d'une incertitude dans les une ou plusieurs caractéristiques déterminées ; et
l'ajustement du signal de sonde sur la base de la qualité déterminée du signal d'échantillon comprenant :

l'ajustement de la fréquence d'injection de telle sorte que la fréquence d'injection est plus espacée de la fréquence d'intérêt, ou
l'ajustement de l'amplitude du signal de sonde.

9. Procédé mis en œuvre par ordinateur selon l'une quelconque des revendications précédentes,

la fréquence d'injection étant espacée de la fréquence d'intérêt d'un delta de fréquence ; et
le delta de fréquence étant maintenu de telle sorte que la fréquence d'injection suit des changements de fréquence de la composante par rapport à la fréquence d'intérêt.

10. Procédé mis en œuvre par ordinateur selon l'une quelconque des revendications précédentes, comprenant en outre :

l'identification d'une pluralité de composantes du signal de réseau électrique ;
la détermination d'une qualité de signal de chacune de la pluralité de composantes ; et
la sélection de la composante parmi la pluralité de composantes sur la base de la composante ayant la qualité de signal la plus grande.

11. Procédé mis en œuvre par ordinateur selon l'une quelconque des revendications précédentes, comprenant en outre :

la détection d'un signal transitoire dans le signal de réseau électrique ;
en réponse à la détection du signal transitoire, le blocage d'une entrée dans le filtre de signal pendant un temps de descente de transitoire ; et

après le temps de descente de transitoire, l'arrêt dudit blocage.

12. Procédé mis en œuvre par ordinateur selon l'une quelconque des revendications précédentes,

le signal de réseau électrique comprenant une pluralité de phases ; et
la génération du signal de sonde comprenant la génération d'un signal de sonde respectif pour chacune de la pluralité de phases.

13. Procédé mis en œuvre par ordinateur selon la revendication 12,
le signal de sonde comprenant une séquence de phase positive et/ou une séquence de phase négative.

14. Dispositif de traitement de données configuré pour réaliser le procédé selon l'une quelconque des revendications 1 à 13.

15. Produit programme informatique comprenant des instruction qui, lorsque le programme est exécuté par un ordinateur, amènent l'ordinateur à réaliser le procédé selon l'une quelconque des revendications 1 à 13.

16. Support lisible par ordinateur comprenant des instruction qui, lorsqu'elles sont exécutées par un ordinateur, amènent l'ordinateur à réaliser le procédé selon l'une quelconque des revendications 1 à 13.

17. Système de réseau électrique comprenant :

un convertisseur de puissance connecté au réseau configuré pour fournir une puissance réactive et/ou active au réseau électrique selon un signal de commande de réseau électrique, et injecter des signaux de puissance dans le réseau électrique en superposant le signal injecté sur la commande de réseau électrique ; et
un contrôleur configuré pour commander le convertisseur de puissance ;
le convertisseur de puissance comprenant le dispositif de traitement de données selon la revendication 14.

*1*

Fig. 1

102G

102C

102S

$f_0$ $f_S$ $f_1$ $f_2$ $f_3$ $f$

$F_b$

A

*Fig. 2*

*Fig. 3*

400

Fig. 4A

| 410A | 410B |
|------|------|
| 402C | 402SA |
|      | 402SA1 |
|      | 402SA2 |
|      | 402SA...N |
|      | 402SB |
|      | 402SB1 |
|      | 402SB2 |
|      | 402SB...N |
| 402C...N | ... |
| ... | ... |

410

Fig. 4B

Fig. 5A

Fig. 5B

Fig. 5C

Fig. 6

EP 4 194 861 B1

Fig. 7

*Fig. 8*

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6208945 B
- GB 2567460 A

- DE 102019214533